# EUROPÄISCHE PATENTANMELDUNG

(11) **EP 1 405 822 A2**
(43) Veröffentlichungstag der Anmeldung: **07.04.2004**
(21) Anmeldenummer: 03022169.1
(22) Anmeldetag: 30.09.2003
(51) Int. Cl.: B81C 1/00, B81B 7/00

(54) **Verfahren zum Herstellen eines Gehaeuses für einen Chip mit einer mikromechanischen Struktur**

(30) Priorität: 02.10.2002 DE 10246101
(71) Anmelder: Infineon Technologies AG, 81669 München (DE)
(72) Erfinder: Daeche, Frank, 81825 München (DE); Dangelmaier, Jochen, 93176 Beratzhausen (DE); Ehrler, Günter, 83607 Holzkirchen (DE); Meckes, Andreas, 81735 München (DE)
(74) Vertreter: Zinkler, Franz

(57) **Zusammenfassung**

Verfahren zum Herstellen eines Gehäuses für einen Chip mit einer mikromechanischen Struktur

Ein Verfahren zum Herstellen eines Gehäuses für einen Chip (20) mit einer mikromechanischen Struktur (22) geht zunächst von einer ersten Basis (10) aus, die auf zumindest einem Teilbereich einer Hauptfläche derselben eine photolithographisch strukturierbare Schicht (12) aufweist. Diese wird strukturiert, um einen Deckel (16) für die mikromechanische Struktur (22) zu erhalten. Ferner wird ein Chip (20) mit der mikromechanischen Struktur (22) bereitgestellt, die an einer Hauptfläche des Chips (20) zwischen ersten Kontaktelementen (24, 26) angeordnet ist. Eine zweite photolithographisch strukturierbare Schicht (28) wird auf zumindest einem Teilbereich der Hauptfläche des Chips (20) aufgebracht und zur Erzeugung einer von einer Wand (30) umgebenen Ausnehmung (32) in derselben(28) im Bereich der mikromechanischen Struktur (22) und zum Freilegen der ersten Kontaktelemente (24, 26) strukturiert. Danach werden die erste Basis (10) und der Chip (20) derart zusammengefügt, daß die mikromechanische Struktur (22) und der Deckel (16) einander zugewandt und zueinander ausgerichtet sind, so daß die Ausnehmung (32) durch den Dekkel (16) abgeschlossen wird. Entfernen der ersten Basis (10) führt zu einem Chip (20) mit Auf-Chip-Hohlraum. Danach werden eine zweiten Basis (40) und der Chip (20) derart zusammengefügt, daß die ersten Kontaktelemente mit der zweiten Basis über eine leitfähige Struktur (34, 36) verbunden werden. Danach wird die zweite Basis (40) zum Freilegen der leitfähigen Struktur (34, 36) entfernt. Das Verfahren ist den kostenmäßigen und größenmäßigen Beschränkungen bekannter Gehäusungstechniken weniger unterworfen.

## Beschreibung

Verfahren zum Herstellen eines Gehäuses für einen Chip mit einer mikromechanischen Struktur

Die vorliegende Erfindung betrifft ein Verfahren zum Herstellen eines Gehäuses für einen Chip mit einer mikromechanischen Struktur.

Chips mit mikromechanischen Strukturen bzw. sogenannte mikromechanische Schaltungen haben einen zunehmend größeren Marktanteil bei Hochfrequenz-Schaltern und Frequenz-Filtern. Eine der Hauptmärkte für derartige Chips mit mikromechanischen Strukturen ist der Mobilfunkmarkt. Ein Chip mit einer mikromechanischen Struktur, der auch als mikromechanische Schaltung bezeichnet wird, ist eine Halbleitervorrichtung, an deren Oberfläche eine mikromechanische Struktur ausgebildet ist. Für derartige Schaltungen werden eigene Gehäusungstechniken benötigt, wobei das Gehäuse einen Hohlraum um die mikromechanische Struktur herum festlegen muß.

Eine im Stand der Technik übliche Vorgehensweise für die Gehäusung eines Chips mit einer mikromechanischen Struktur besteht darin, aus Keramik bestehende Gehäusungselemente mit einem Hohlraum einzusetzen. Diese Keramikgehäusestrukturen sind für die sich heute ergebenden Technikanforderungen sowohl zu teuer als auch zu groß. Typische Dimensionen derartiger Keramikgehäuse für einen Chip mit einer mikromechanischen Struktur liegen bei etwa 3 mm x 3 mm x 1,3 mm. Diese Abmessungen können mit den üblichen Keramikgehäusetechnologien nicht weiter reduziert werden.

Ein alternatives Verfahren schlägt die WO 9952209 A1 vor, die ein Verfahren zum Häusen einer Akustowellenvorrichtung ohne Verunreinigung eines auf einer Hauptfläche derselben angeordneten aktiven Bereiches offenbart. Ein Substrat, das auf einer Oberseite desselben leitfähige Anschlußflächen sowie einen Damm 26 aufweist, wird mit der Akustowellenvorrichtung derart verbunden, daß sich die Hauptfläche der Akustowellenvorrichtung 10 und die Oberseite des Substrates gegenüberliegen, wodurch ein Hohlraum um den aktiven Bereich gebildet wird und die leitfähigen Anschlußflächen mit Kontakthöckern auf der Akustowellenvorrichtung verbunden werden. Die entstehende Gehäusestruktur umfaßt die Akustowellenvorrichtung, das Substrat sowie den dazwischenliegenden Hohlraum, der anschließend durch ein Unterfüllungsmaterial umgeben wird. Nachteilhaft an der entstehenden Struktur ist die beträchtliche Höhe durch das Vorhandensein des Anbringungssubstrates.

Ausgehend von diesem Stand der Technik liegt der vorliegenden Erfindung daher die Aufgabe zugrunde, ein Verfahren zum Herstellen eines Gehäuses für einen Chip mit einer mikromechanischen Struktur zu schaffen, das nicht länger den kostenmäßigen und größenmäßigen Beschränkungen bekannter Gehäusungstechniken unterworfen ist.

Diese Aufgabe wird durch ein Verfahren gemäß Patentanspruch 1 gelöst.

Gemäß einem erfindungsgemäßen Verfahren wird auf einer Hauptoberfläche einer ersten Basis eine erste photolithographisch strukturierbare Schicht innerhalb zumindest eines Teilbereichs der Hauptoberfläche der ersten Basis aufgebracht und photolithographisch strukturiert, um einen Deckel für die mikromechanische Struktur zu erhalten. Eine zweite photolithographisch strukturierbare Schicht wird auf zumindest einen Teilbereich einer Hauptfläche eines Chips mit der mikromechanischen Struktur, die an einer Hauptfläche des Chips zwischen ersten Kontaktelementen angeordnet ist, aufgebracht, und geeignet photolithographisch strukturiert, um eine von einer Wand umgebene Ausnehmung in der zweiten photolithographisch strukturierbaren Schicht im Bereich der mikromechanischen Struktur zu erzeugen, und um die ersten Kontaktelemente freizulegen. Anschließend werden die erste Basis und der Chip in der Weise zusammengefügt, daß die mikromechanische Struktur und der Deckel einander zugewandt und zueinander ausgerichtet sind, so daß die Ausnehmung durch den Deckel abgeschlossen wird, wodurch ein Auf-Chip-Hohlraum erhalten wird. Durch Entfernen der Basis wird somit ein Chip mit Auf-Chip-Hohlraum erhalten. Eine zweite Basis wird mit dem so erhaltenen Chip mit Auf-Chip-Hohlraum in der Weise zusammengefügt, daß die ersten Kontaktelemente mit der zweiten Basis über eine leitfähige Struktur verbunden werden. Abschließend wird die zweite Basis zum Freilegen der leitfähigen Struktur entfernt.

Bevorzugte Ausführungsbeispiele der vorliegenden Erfindung werden nachfolgend unter Bezugnahme auf die beiliegenden Zeichnungen näher erläutert. Es zeigen:
- Fig. 1A und 1B: eine erste Basis, die als Träger des Deckels für den Hohlraum um die mikromechanische Struktur dient, in zwei Verfahrensschritten gemäß einem Ausführungsbeispiel der vorliegenden Erfindung;
- Fig. 2A - 2C: einen Chip mit der mikromechanischen Struktur in drei weiteren Verfahrensschritten zur Herstellung des Gehäuses gemäß einem Ausführungsbeispiel der vorliegenden Erfindung;
- Fig. 3A - 3C: die in Fig. 1A und 1B hergestellte erste Basis nach Zusammenfügung mit dem Chip aus Fig. 2A-2C bei drei weiteren Verfahrensschritten zum Herstellen des Gehäuses nach einem Ausführungsbeispiel der vorliegenden Erfindung;
- Fig. 4A - 4C: die sich aus den Verfahrensschritten von Fig. 3A-3C ergebende Struktur nach Zusammenfügung mit einer zweiten Basis bei drei weiteren Verfahrensschritten zum Herstellen des Gehäuses gemäß einem Ausführungsbeispiel der vorliegenden Erfindung;
- Fig. 5: eine sich bei einem dem Schritt von Fig. 4B entsprechenden Verfahrensschritt einstellende Struktur nach einer abgewandelten Ausführungsform des Verfahrens;
- Fig. 6A: eine mit Metallinseln versehene zweite Basis zur Herstellung des Gehäuses gemäß einem weiteren Ausführungsbeispiel der vorliegenden Erfindung;
- Fig. 6B: eine sich auf einen dem Schritt von Fig. 4C entsprechenden Verfahrensschritt hin einstellende Struktur bei Verwendung der zweiten Basis nach Fig. 6A; und
- Fig. 7A und 7B: eine Vorderansicht und eine Unteransicht einer sich auf einen dem Schritt von Fig. 4B entsprechenden Verfahrensschritt hin ergebenden Struktur gemäß einem weiteren Ausführungsbeispiel der vorliegenden Erfindung.

Bevor Bezug nehmend auf die Figuren bevorzugte Ausführungsbeispiele der vorliegenden Erfindung näher erörtert werden, wird darauf hingewiesen, daß gleiche oder funktionsgleiche Elemente in den Figuren mit gleichen bzw. ähnlichen Bezugszeichen versehen sind, und daß zur Vermeidung von Wiederholungen eine erneute Beschreibung dieser Elemente vermieden wird.

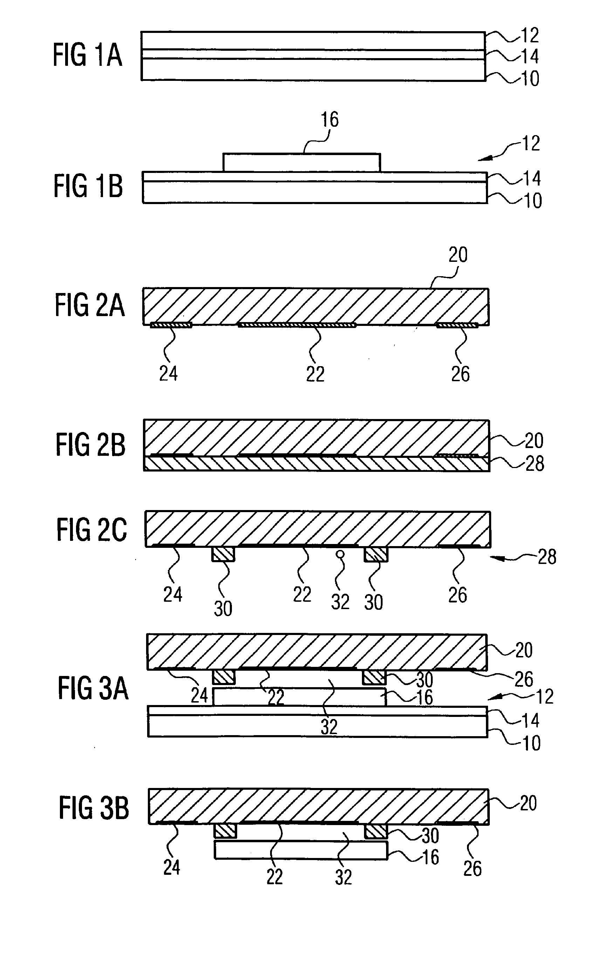

In den Verfahrensschritten von Fig. 1A und 1B wird zunächst die Vorbereitung eines Tragewafers bzw. einer ersten Basis beschrieben, die als Träger für einen Deckel für einen Hohlraum dienen soll, der eine mikromechanische Struktur eines Chips umgibt, für welchen das Gehäuse hergestellt werden soll.

Wie in Fig. 1A gezeigt ist, wird zunächst der Tragewafer 10 bereitgestellt, der beispielsweise aus einem Halbleitermaterial, wie z.B. Si besteht. Alternativ kann für die erste Basis 10 jedwedes andere Material verwendet werden, welches mit dem im folgenden zu erläuternden Prozeßschritten verträglich ist. Auf einer Hauptfläche des Wafers 10 befindet sich eine photoempfindliche Epoxidschicht 12, wobei zwischen Epoxidschicht 12 und Wafer 10 eine Opferschicht 14 angeordnet ist. Die Opferschicht 14 wird, wie es im folgenden erörtert werden wird, dazu dienen, den Wafer 10 von einem aus der Epoxidschicht 12 gebildeten Deckel zu trennen.

Wie in Fig. 1B gezeigt ist, wird in einem nächsten Verfahrensschritt ein photolithographisches Strukturieren der photoempfindlichen Epoxidschicht 12 vorgenommen, um einen Epoxidbereich 16 zu erhalten, der als Deckel für die mikromechanische Struktur dienen soll. Bei dieser Photolithographie müssen zumindest diejenigen Bereiche der photoempfindlichen Epoxidschicht 12 belichtet werden, so daß sie nach der Entwicklung stehen bleiben, welche dem "aktiven" Bereich um die mikromechanische Struktur des Chips herum nach Zusammenbau des Gehäuses gegenüberliegen.

Die nunmehr unter Bezugnahme auf Fig. 2A bis 2C zu erläuternden Verfahrensschritte werden an dem die mikromechanische Struktur umfassenden Chip 20 ausgeführt. Unter dem Begriff "Chip" im Sinne der vorliegenden Anmeldung sei jede Halbleitervorrichtung verstanden, an der eine mikromechanische Struktur ausgebildet ist. Als mikromechanische Struktur ist beispielsweise ein BAW- (BAW = Bulk Acoustic Wave) Filter denkbar.

Wie in Fig. 2A gezeigt ist, hat der Chip 20 an seiner Unterseite eine mikromechanische Struktur 22, die elektrisch an ebenfalls an der Unterseite des Chips 20 angeordnete Kontakthügel 24, 26 angeschlossen ist. Soweit der bereitgestellte Chip 20 mit der mikromechanischen Struktur diese Kontakthügel 24, 26 noch nicht aufweist, bedarf es der Durchführung eines entsprechenden Metallisierungsverfahrensschrittes zur Erzeugung der unterseitigen Kontakthügel 24, 26 ("Underbump-Metallisierung").

Bei dem in Fig. 2B gezeigten Verfahrensschritt wird eine Beschichtung auf die Oberfläche des Chips bzw. des Halbleiterwafers 20 durch beispielsweise Schleuderbeschichtung mit einer photoempfindlichen Epoxidschicht vorgenommen. Diese Schleuderbeschichtung kann zum Aufbau einer gewünschten Schichtdicke, die die Stärke des später zu realisierenden Hohlraumes festlegt, mehrfach wiederholt werden, bis sich eine zweite photoempfindliche Epoxidschicht 28 von der gewünschten Stärke auf der Unterseite des Chips 20 aufgebaut hat.

Wie in Fig. 2C verdeutlicht ist, erfolgt nunmehr ein photolithographisches Strukturieren der zweiten Epoxidschicht 28 zur Erzeugung einer von einer Wand bzw. einem Damm 30 umgebenen Ausnehmung 32 sowie zum Freilegen der Kontakthügel 24, 26. Die Wand 30 schließt den "aktiven Bereich" um die mikromechanische Struktur 22 herum ein.

Die nachfolgend bezugnehmend auf die Fig. 3A-3C gezeigten Verfahrensschritte betreffen das Zusammenfügen des wie oben beschrieben vorbereiteten Chips und der wie oben beschrieben vorbereiteten Basis sowie die an der sich ergebenden Struktur vorgenommenen Bearbeitungen.

Wie in Fig. 3A gezeigt ist, findet nach Vorbereitung von Chip 20 und Basis 10 ein erster Zusammenfügeschritt statt, in welchem die Basis 10 und der Chip 20 in der Weise zusammengefügt werden, daß die mikromechanische Struktur 22 und der Deckel 16 einander zugewandt und zueinander ausgerichtet sind, so daß die durch die Wand 30 definierte Ausnehmung 32 durch den Deckel 16 abgeschlossen wird, wodurch ein Auf-Chip-Hohlraum 32 auf dem Chip 20 um die mikromechanische Struktur 22 herum erhalten wird. Die Wand 30 erzeugt folglich zusammen mit der ersten Epoxidschicht 12 aus der Ausnehmung 32 einen geschlossenen Hohlraum, der die mikromechanische Struktur 22 umgibt.

Bei dem in Fig. 3B gezeigten folgenden Verfahrensschritt wird der Trägerwafer 10 von dem dem Deckel bildenden Epoxidbereich 16 abgelöst, indem die Opferschicht 14 durch ein geeignetes Ätzverfahren weggeätzt wird. Das Ergebnis ist der in Fig. 3B gezeigte Chip mit Auf-Chip-Hohlraum um die mikromechanische Struktur 22. Für das Ablösen könnte jedoch auch ein alternatives Verfahren verwendet werden, wie z.B. Schleifen, wobei auf die Opferschicht 14 verzichtet werden könnte.

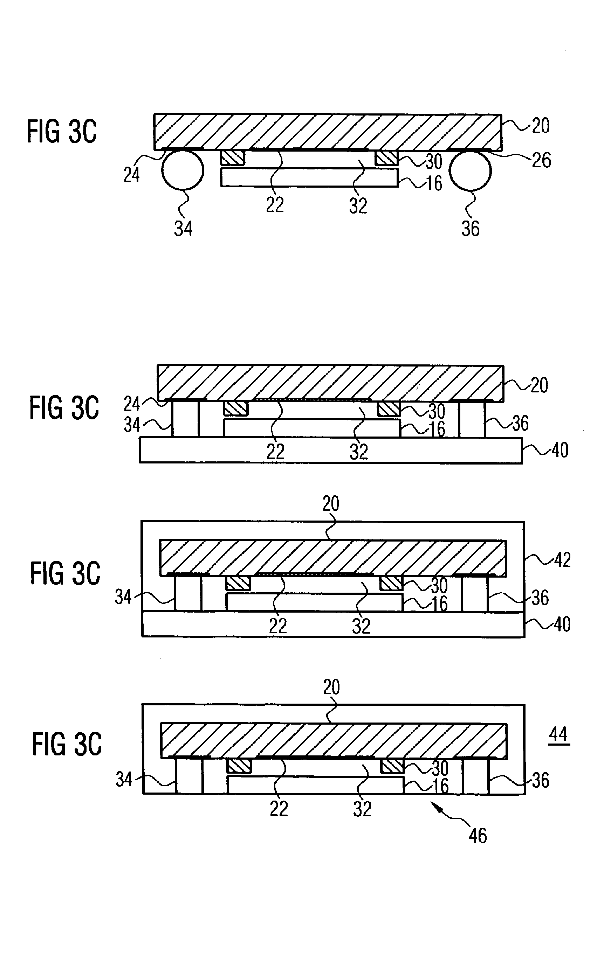

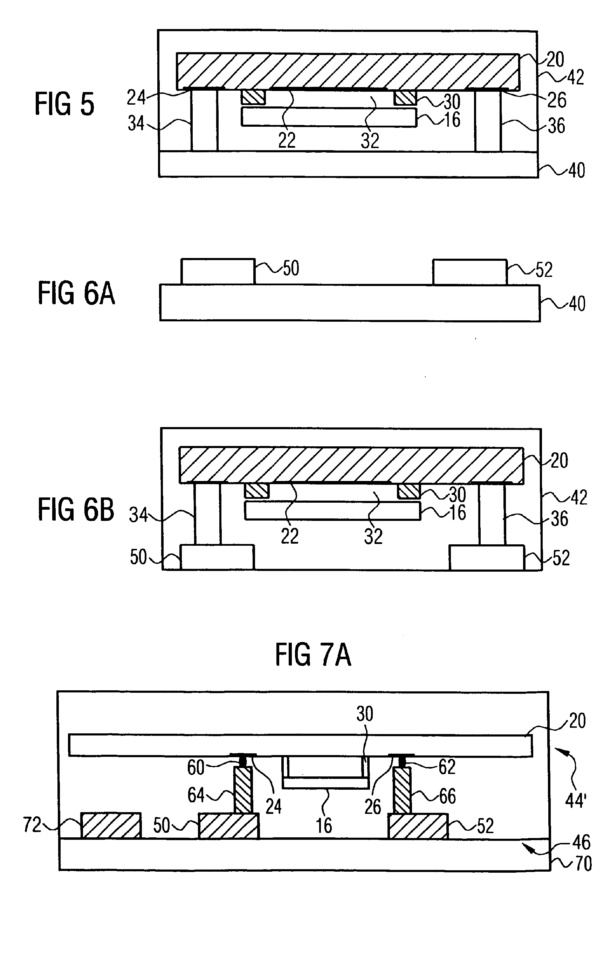

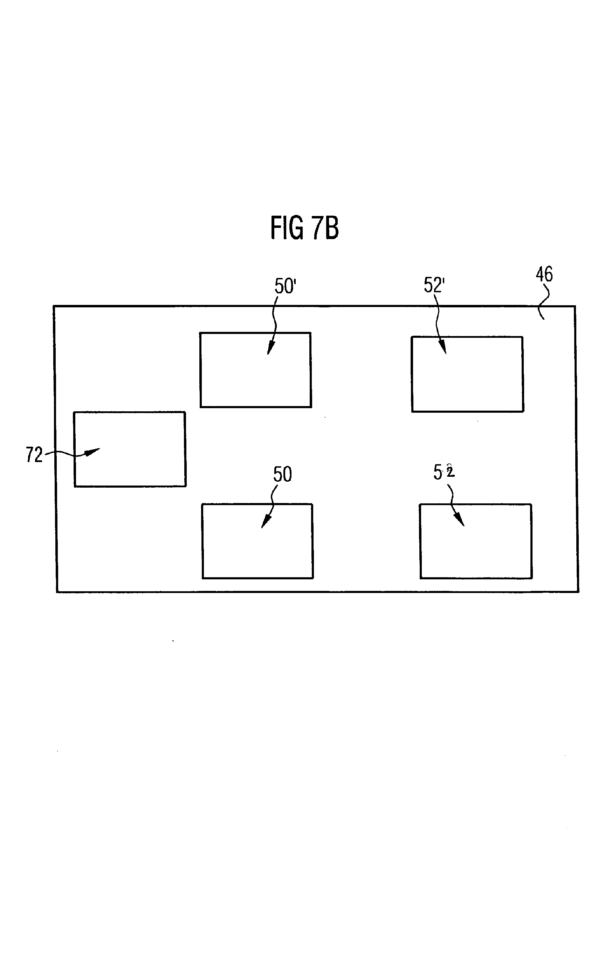

Bei einem in Fig. 3C verdeutlichten Verfahrensschritt werden Lötmittelkugeln 34, 36 auf die Kontakthügel 24, 26 aufgebracht. Die Lötmittelkugeln 34, 36 werden im folgenden Verfahrensschritt als zumindest ein Teil einer leitfähigen Struktur dazu verwendet, die Kontakthügel 24, 26 mit einer aus Kupfer bestehenden Basis zu verbinden, die anschließend wieder entfernt wird, wodurch die leitfähige Struktur einen leitfähigen Verbindungsweg zwischen Kontakthügeln 24, 26 und Gehäuseunterseite bzw. Anschlußflächenseite schafft. Eine alternative Vorgehensweise zur Verbindung besteht in der Erzeugung einer Säulenhöckerverbindung ("stud bumping"), wie es Bezug nehmend auf Fig. 7 kurz erläutert werden wird.

Die nachfolgend bezugnehmend auf Fig. 4A-4C beschriebenen Verfahrensschritte beziehen sich auf die Bearbeitung des wie oben beschrieben vorbereiteten Auf-Chip-Hohlraum-Chips zum Abschließen dieser Struktur, wobei hierzu eine weitere Kupferbasis als Opfersubstrat verwendet wird, um beim Abschließen der Struktur die untere Anschlußfläche des schließlichen Gehäuses zu definieren und anschließend entfernt zu werden.

Wie in Fig. 4A gezeigt ist, werden zunächst der wie in Fig. 3C vorbereitete Chip mit Auf-Chip-Hohlraum und eine Kupfer-Basis 40 zusammengefügt, derart, daß die Lötmittelkugeln 34, 36 eine leitfähige Struktur von den Kontaktflächen 24, 26 aus bis zu derjenigen Hauptfläche der Kupfer-Basis 40 bilden, die dem Chip 20 zugewandt ist. Diese Verbindung der Kontakthügel 24, 26 zu der zugewandten Hauptfläche der Kupfer-Basis 40 findet durch Löten oder einen Thermokompressionsprozeß statt. Bei dem vorliegenden Ausführungsbeispiel findet das Zusammenfügen derart statt, daß nach dem Zusammenfügen der Chip 20 mit dem Deckel 16 des Auf-Chip-Hohlraumes 32 die Kupfer-Basisplatte 40 berührt. Die beim Löten oder dem Thermokompressionsprozeß angewandten Temperaturen sollten über den Temperaturen liegen, wie sie bei dem anschließenden Schritt von Fig. 4B zum Abschließen der bis jetzt erzeugten Struktur angewendet werden.

Fig. 4B zeigt einen Zustand, wie er sich nach dem nächsten Verfahrensschritt einstellt, nämlich dem Abschließen der so weit erzeugten Struktur von Fig. 4A mit einer Deckschicht 42. Dieser Verfahrensschritt findet vorzugsweise bei einem erhöhten Temperaturniveau statt, bei dem ein die Deckschicht 42 bildendes Kunststoffmaterial verflüssigt ist. Bei dem abschließenden Absinken des Temperaturniveaus kommt es zu einer Kontraktion des Kunststoffmaterials, welche zu einer Festigung der bis dahin gefertigten Struktur beiträgt.

Bei dem in Fig. 4C gezeigten abschließenden Verfahrensschritt wird die Basis 40 durch einen Kupfer-Ätzprozeß entfernt, wodurch die durch die Lötmittelkugeln 34, 36 gebildeten leitfähigen Strukturen an der freigelegten Hauptfläche der Struktur aus Deckschicht 42 und Chip 20 mit Auf-Chip-Hohlraum 32 für eine spätere Kontaktierung zugänglich werden. Das so erzeugte Gehäuse ist in Fig. 4C allgemein mit 44 angezeigt. Die als Anbringungsfläche bzw. Kontaktierungsfläche dienende Unterseite des Gehäuses 44 ist mit 46 angezeigt. Die Unterseite 46 setzt sich aus drei Teilen zusammen, nämlich einem, der durch das Epoxid des Deckels 16 gebildet wird, einem, der durch das leitfähige Material der Lötmittelkugeln 34, 36 gebildet wird, und einem, der durch das Kunststoff der Deckschicht 42 gebildet wird.

Nach Durchführung des unter Bezugnahme auf Fig. 4C beschriebenen Kupferätzschrittes wird vorzugsweise ein Goldplattieren der freigelegten Kontaktbereiche der leitfähigen Strukturen 34, 36 an der nun freiliegenden Unterseite 46 des Gehäuses 44 vorgenommen.

Gemäß einer Variante des oben beschriebenen Verfahrens zur Herstellung des Gehäuses wird bei dem Schritt von Fig. 4A, d.h. dem Zusammenfügen des Chips mit Auf-Chip-Hohlraum und der Kupfer-Basisplatte, das Zusammenfügen derart durchgeführt, daß nach Zusammenfügen die Lötmittelkugeln 34, 36 sich von den Kontakthügeln 24 und 26 bis zur dem Chip 20 zugewandten Hauptfläche der Kupferbasisplatte 40 leitfähige Strukturen ergeben und zwischen dem den Deckel bildenden Epoxid-Bereich 16 und der dem Chip 20 zugewandten Hauptfläche der Kupfer-Basisplatte 40 ein Zwischenraum verbleibt, so daß, wie es in Fig. 5 gezeigt ist, nach dem Abschließen der so entstehenden Struktur durch die Deckschicht 42 die in Fig. 5 gezeigte Struktur entsteht. Das beim Abschließen verwendete Kunststoffmaterial bewirkt durch die beim Absinken der Temperatur entstehende Kontraktion, daß die Wand 30 fest an den gegenüberliegenden als Deckel dienenden Epoxidabschnitt gepreßt wird. Zum Fertigstellen des Gehäuses nach Fig. 5 sind lediglich die Bezug nehmend auf Fig. 4C beschriebenen Verfahrensschritte durchzuführen. Ein Gehäuse, das nach der Variante nach Fig. 5 hergestellt ist, unterscheidet sich von einer Unterseite des Gehäuses nach Fig. 4C dadurch, daß es sich lediglich in zwei Teile gliedert, nämlich einen durch das Kunststoffmaterial der Deckschicht 42 gebildeten und einen durch die durch die Lötmittelkugeln 34, 36 definierten Kontaktstrukturen gebildeten.

Eine weitere Variante des oben Bezug nehmend auf die Fig. 1A-4C beschriebenen Verfahrensablaufes wird Bezug nehmend auf Fig. 6A und 6B beschrieben. Bei diesem Ausführungsbeispiel wird anstelle der reinen Kupfer-Basisplatte 40, wie sie bei dem Verfahrensschritt 4A verwendet worden ist, eine bereits vorbereitete Basis 40 verwendet, bei der auf einer Hauptseite, die später beim Zusammenfügen dem Chip mit Auf-Chip-Hohlraum zugewandt sein soll, Metallinseln 50, 52 ausgebildet sind. Bevorzugt sind die Metallinseln als Nickel-plattierte Inseln auf der Kupfer-Basis 40 ausgeführt, welche mit einer Goldplattierung überzogen sind. Die Art der Anordnung dieser Inseln 50, 52 und die Größe dieser Inseln 50, 52 sind so gewählt, daß sie den Kontakthügeln 24, 26 an der Unterseite des Chips 20 entsprechen. Bei dieser Variante wird also die wie in Fig. 6A gezeigt vorbereitete Kupfer-Basisplatte 40 wie Bezug nehmend auf Fig. 4A beschrieben mit dem Chip mit Auf-Chip-Hohlraum zusammengefügt, derart, daß deren erwähnten Hauptflächen einander zugewandt sind, und daß die jeweils einander gegenüberliegenden Metallinseln 50, 52 und Kontakthügel 24, 26 über die Lötmittelkugeln 34, 36 durch Löten oder einen Thermokompressionsprozeß miteinander verbunden werden, und zwar derart, daß entweder, wie in Fig. 4A gezeigt, der den Deckel bildende Epoxid-Abschnitt 16 die Kupfer-Basisplatte 40 berührt, oder daß, wie in Fig. 5 gezeigt ist, ein Zwischenraum zwischen dem Abschnitt 16 und der Basisplatte 40 verbleibt. Das sich gemäß dieser Variante ergebende Gehäuse nach Durchführung der Schritte gemäß Fig. 4A-4C ist in Fig. 6B gezeigt. Der Vorteil dieser Vorgehensweise besteht darin, daß der Querschnitt der Anschlußflächen bzw. die Form der Kontaktbereiche an der Unterseite des Gehäuses je nach Bedarf variiert werden können, was es ermöglicht, unterschiedliche Chips in Gehäuse mit gleicher Kontaktbereichsanordnung anzuordnen. Die Metallinseln 50, 52 werden beispielsweise auf übliche Weise durch einen Photoprozeß auf der Kupfer-Basisplatte 40 erzeugt bzw. strukturiert.

Ein spezielles Ausführungsbeispiel eines gemäß einem erfindungsgemäßen Verfahren hergestellten Gehäuses ist in Fig. 7A und 7B gezeigt. Fig. 7A zeigt eine Vorderprojektionsansicht, während Fig. 7B die Unter- bzw. Anbringungsseite des Gehäuses zeigt. Das Gehäuse ist allgemein mit 44' angezeigt. Es ist nach dem Verfahren von Fig. 1A-4C mit den Varianten von Fig. 5 und Fig. 6A und 6B hergestellt worden, d.h. es existiert ein Zwischenraum zwischen dem den Deckel bildenden Epoxid 16 und der Unter- bzw. Anbringungshauptfläche 46 des Gehäuses 44' und die die leitfähige Verbindung zu der Unter- bzw. Anbringungsseite des Gehäuses 44' herstellenden leitfähigen Strukturen für die Kontakthügel 24, 26 auf der Unterseite des Chips 20 umfassen auch die Metallinseln 50, 52. Als Variante zu dem Lötmittelaufbringungsschritt von Fig. 3C wurde bei dem Gehäuse 44' von Fig. 7A und 7B eine Säulenhöckerverbindung verwendet. Die leitfähigen Strukturen, die einen leitfähigen Verbindungsweg von den Kontakthügeln 24, 26 auf der Unterseite des Chips 20 zu der Anbringungsseite 46 des Gehäuses 44' liefern, umfassen deshalb Säulenhöcker 60, 62, Säulen aus Nickel und Gold 64, 66 sowie die im vorhergehenden erwähnten Metallinseln 50, 52 aus Nickel. In Fig. 7A ist das Gehäuse 44' in dem Zustand dargestellt, da dasselbe bereits an einem Anschlußleitungsrahmen bzw. eine gedruckte Schaltungsplatine 70 angebracht ist. Um die an der Unterseite 46 des Gehäuses 44' entstehende Kontaktbereichsanordnung an die auf der Platine 70 vorgesehene Anschlußkonfiguration anzupassen, und um eine gedruckte Schaltungsplatine 70 mit einheitlichen Anschluß konfigurationen herzustellen, sind die Metallinseln 50, 52 bzw. 50' und 52' (nur in Fig. 7B sichtbar) auf der Kupfer-Basisplatte 40 geeignet angeordnet und dimensioniert worden. Zusätzlich ist eine Dummy-Metallinsel 72 beim Strukturieren des Metalls auf der Kupfer-Basisplatte 40 gebildet worden, welche nicht mit einem der Kontakthügel auf der Unterseite des Chips 20 verbunden ist sondern lediglich als Dummy-Anschluß für das Löten auf die Platine 70 dient. Gemäß diesem Ausführungsbeispiel von Fig. 7A und 7B kann folglich für jedweden Chip 20 eine Anschluß-Konfiguration erreicht werden, wie sie in Fig. 7B gezeigt ist, und die beispielsweise als Einheitskonfiguration dient. Anders ausgedrückt, kann für jeden Chip ein Gehäuse mit einer Anschluß-Konfiguration erzielt werden, die mit der Ziel-Anschluß-Konfiguration auf einer gewünschten Platine 70 angepaßt ist, unabhängig von Zahl der Anschlüsse und der Art des zu häusenden Chips.

Wie es die vorhergehenden Ausführungsbeispiele gezeigt haben, ist es durch die vorliegenden Erfindung folglich möglich, Anschluß-kompatible Gehäuse herzustellen, ohne daß hierfür zusätzliche Umverdrahtungsebenen notwendig sind. Zudem wird es ermöglicht, die Anschluß-Konfiguration auf der Unterseite des Gehäuses, d.h. den Footprint bzw. Fußabdruck, variabel an die Wünsche des Kunden anzupassen. Zudem können basierend auf dem erfindungsgemäßen Verfahren Gehäuse mit geringen Ausmaßen hergestellt werden, insbesondere geringer Größe, wie z.B. mit Abmessungen von 1,5 mm in lateraler Richtung und 0,4 - 0,6 mm in Höhenrichtung. Auch der Anschlußflächenaufbau an sich, kann durch das Vorsehen der Metallinseln und der Zwischenverbindungssäulen variabel gestaltet werden, um an die jeweilige Verbindungstechnik bezüglich der Platine 70 angepaßt zu sein, wie z.B. Löten, Bonden oder Kleben. In dem Fall der Säulen-Höckerverbindung nach Fig. 7A und 7B sind Säulen ohne oder mit Überwuchs möglich. Im Vergleich zu Keramikgehäusen ergeben sich bessere Verankerungsmöglichkeiten zur Stabilität des Gehäuses, und es kann eine bessere Zuverlässigkeit, wie z.B. auf JEDEC- (JEDEC = Joint Electronic Device Engineering Council) Ebene, erreicht werden.

In Bezug auf die Metallinseln von Fig. 6A bzw. Fig. 7A wird darauf hingewiesen, daß diese eine Außenkontur mit Vorsprüngen und Rücksprüngen bzw. einen Überwuchs für eine bessere Verankerung in dem Deckschichtmaterial aufweisen können. Diese Außenkontur bietet eine verbesserte Verankerung der Metallinseln in dem Deckschichtmaterial.

Bei den oben beschriebenen Verfahren wird von einer aus Kupfer bestehenden Basisplatte ausgegangen. Da die Basisplatte lediglich eine Opferstruktur darstellt, kann anstelle von Kupfer jedes andere leicht entfernbare Material, vorzugsweise ätztechnisch entfernbare Material, für die Basisplatte 40 verwendet werden. Ähnliches gilt, wie bereits erwähnt, für den Trägerwafer von Fig. 1A, 1B.

Für die Metallinseln und Kontakthöcker können anstelle der Verwendung von Nickel als Grundmaterial mit Goldplattierung als Überzug beliebige andere Kontaktmaterialien eingesetzt werden.

Bei den beschriebenen bevorzugten Ausführungsbeispielen bestehen die photolithographisch strukturierbaren Schichten aus einem photoempfindlichen Epoxidmaterial, das durch Belichten bzw. Nicht-Belichten von Teilen des Epoxidmaterials entfernt wird oder stehen bleibt. Gleichfalls ist es jedoch möglich, die photolithographisch strukturierbaren Schichten durch beliebige ätzbare Materialien zu bilden, die mit Photomasken abgedeckt sind. In Abweichung zu den oben beschriebenen bevorzugten Ausführungsbeispielen kann eine Umhüllung der gefertigten Gehäusestruktur mittels Vakuum-Siebdruck oder Umspritzen vorgenommen werden.

## Patentansprüche

1. Verfahren zum Herstellen eines Gehäuses für einen Chip (20) mit einer mikromechanischen Struktur (22), mit folgenden Schritten:
(a) Bereitstellen einer ersten Basis (10), die auf zumindest einem Teilbereich einer Hauptfläche derselben eine photolithographisch strukturierbare Schicht (12) aufweist;
(b) photolithographisches Strukturieren der ersten photolithographisch strukturierbaren Schicht (12), um einen Deckel (16) für die mikromechanische Struktur (22) zu erhalten;
(c) Bereitstellen eines Chips (20) mit der mikromechanischen Struktur (22), die an einer Hauptfläche des Chips (20) zwischen ersten Kontaktelementen (24, 26) angeordnet ist;
(d) Aufbringen einer zweiten photolithographisch strukturierbaren Schicht (28) auf zumindest einem Teilbereich der Hauptfläche des Chips (20);
(e) photolithographisches Strukturieren der zweiten photolithographisch strukturierbaren Schicht (28) zur Erzeugung einer von einer Wand (30) umgebenen Ausnehmung (32) in der zweiten photolithographisch strukturierbaren Schicht (28) im Bereich der mikromechanischen Struktur (22) und zum Freilegen der ersten Kontaktelemente (24, 26);
(f) Zusammenfügen der ersten Basis (10) und des Chips (20) in der Weise, daß die mikromechanische Struktur (22) und der Deckel (16) einander zugewandt und zueinander ausgerichtet sind, so daß die Ausnehmung (32) durch den Deckel (16) abgeschlossen wird, wodurch ein Auf-Chip-Hohlraum (32) erhalten wird;
(g) Entfernen der ersten Basis (10), um einen Chip (20) mit Auf-Chip-Hohlraum zu erhalten;
(h) Zusammenfügen einer zweiten Basis (40) und des Chips (20) mit Auf-Chip-Hohlraum in der Weise, daß die ersten Kontaktelemente mit der zweiten Basis über eine leitfähige Struktur (34, 36; 60, 62, 64, 66; 50, 52) verbunden werden; und
(i) Entfernen der zweiten Basis (40) zum Freilegen der leitfähigen Struktur (34, 36; 60, 62, 64, 66; 50, 52).

2. Verfahren nach Anspruch 1, bei dem die zweite Basis (40) zweite Kontaktelemente (50, 52) auf der Hauptfläche der zweiten Basis (40) aufweist, wobei der Schritt (h) derart durchgeführt wird, daß jeweils erste und zweite Kontaktelemente (34, 36, 50, 52) miteinander verbunden werden.

3. Verfahren nach Anspruch 1 oder 2, bei dem die zweiten Kontaktelemente (50, 52) Nickelinseln (50, 52) bestehen.

4. Verfahren nach einem der Ansprüche 1 bis 3, das ferner den Schritt des Aufbringens von Lötmittelkugeln (34, 36) auf die ersten Kontaktelemente (24, 26) vor dem Schritt (h) aufweist.

5. Verfahren nach einem der Ansprüche 1 bis 4, bei dem die zweite Basis (40) aus Kupfer besteht.

6. Verfahren nach Anspruch 5, bei dem der Schritt (i) ein Wegätzen der zweiten Basis (40) umfaßt.

7. Verfahren nach einem der Ansprüche 1 bis 6, bei dem die erste und/oder die zweite photolithographisch strukturierbare Schicht (12, 28) aus einem photoempfindlichen Epoxidharz besteht.

8. Verfahren gemäß einem der Ansprüche 1 bis 7, bei der der Schritt (a) das Aufbringen der ersten photolithographisch strukturierbaren Schicht (12) auf zumindest einem Teilbereich einer Hauptfläche einer ersten Basis (10) aufweist, auf der sich bereits eine Opferschicht (14) befindet, und bei dem der Schritt (g) das Wegätzen der Opferschicht (14) aufweist.

9. Verfahren gemäß einem der Ansprüche 1 bis 8, bei dem der Schritt (h) derart durchgeführt wird, daß nach Zusammenfügen ein Zwischenraum zwischen dem Deckel (16) und der zweiten Basis (40) entsteht.

10. Verfahren gemäß einem der Ansprüche 1 bis 8, bei dem der Schritt (h) derart durchgeführt wird, daß nach Zusammenfügen sich der Deckel (16) und die zweite Basis (40) berühren.

11. Verfahren gemäß einem der Ansprüche 1 bis 10, das ferner den Schritt des Abschließens einer sich nach Schritt (h) ergebenden Struktur aus dem Chip (20) mit Auf-Chip-Hohlraum und der zweiten Basis (40) mit einer Deckschicht (42) aufweist, wodurch nach Schritt (i) die leitfähige Struktur an einer freigelegten Hauptfläche der durch den Schritt des Abschließens abgeschlossenen Struktur freiliegt.

12. Verfahren gemäß einem der Ansprüche 1 bis 11, bei dem die Deckschicht (14) aus Kunststoffmaterial besteht.

13. Verfahren gemäß einem der Ansprüche 1 bis 12, das vor dem Schritt (h) das Vorsehen einer Höckersäulenstruktur auf den ersten Kontaktelementen aufweist.
